# FASCICULE DE BREVET EUROPEEN

(11) **EP 2 258 003 B1**
(45) Date de publication et mention de la délivrance du brevet: **05.06.2013**
(21) Numéro de dépôt: 09734486.5
(22) Date de dépôt: 27.03.2009
(51) Int. Cl.: H01L 41/04, F04B 43/04, D06F 75/14

(54) **APPAREIL ELECTROMENAGER COMPORTANT UNE POMPE PIEZO-ELECTRIQUE MUNIE D'UN CIRCUIT D'ALIMENTATION ELECTRIQUE SIMPLIFIE**
HAUSHALTSANWENDUNG MIT EINER PIEZOELEKTRISCHEN PUMPE MIT VEREINFACHTEM STROMZUFUHRSCHALTKREIS
DOMESTIC APPLIANCE COMPRISING A PIEZOELECTRIC PUMP PROVIDED WITH A SIMPLIFIED POWER SUPPLY CIRCUIT

(30) Priorité: 28.03.2008 FR 0801706
(43) Date de publication de la demande: 08.12.2010
(73) Titulaire: SEB S.A., 69130 Ecully (FR)
(72) Inventeur: MANDICA, Franck, F-69340 Francheville (FR); CUBIZOLLES, Serge, F-38780 Oytier Saint Oblas (FR); LAVILLAT, Olivier, F-74600 Quintal (FR); COUET, Bertrand, F-69700 Loire sur Rhône (FR)
(74) Mandataire: Bourrières, Patrice
(86) Numéro de dépôt international: PCT/FR2009/000343
(87) Numéro de publication internationale: WO 2009/130407

(56) Documents cités:
- EP-A- 0 322 899
- EP-A- 0 459 559
- WO-A-00/36302
- FR-A1- 2 523 164
- JP-A- 61 058 286
- US-A- 4 708 600

## Description

La présente invention concerne un appareil électroménager équipé d'une pompe piézo-électrique munie d'un circuit d'alimentation électrique.

Dans le domaine des appareils du type précité, la pompe piézo-électrique comporte généralement une chambre présentant une membrane souple sur laquelle est fixé un élément piézo-électrique. La chambre comporte un conduit d'amenée et un conduit de sortie comprenant tous deux un clapet anti retour.

En fonctionnement, l'élément piézo-électrique va vibrer à la fréquence d'une tension alternative fournie par un circuit d'alimentation et avec une amplitude pilotée par cette tension, générant ainsi une succession de cycles d'aspiration et de refoulement.

On connaît des circuits d'alimentation d'une telle pompe piézo-électrique, comportant une électronique complexe qui, à partir de la tension disponible du réseau électrique ou d'une batterie, recrée un signal de fréquence et de forme adapté pour faire osciller l'élément piézo-électrique de la pompe.

Ce type de circuits d'alimentation présente l'inconvénient de mettre en oeuvre des composants électroniques chers et nombreux, source de pannes potentielles.

Le but de la présente invention est de remédier aux inconvénients précités et de proposer un appareil électroménager équipé d'une pompe piézo-électrique dont le circuit d'alimentation, à partir du réseau électrique, est simple et économique à mettre en oeuvre.

Un autre but de l'invention est de proposer un appareil électroménager équipé d'une pompe piézo-électrique dont le circuit d'alimentation présente une grande fiabilité et un fonctionnement sûr.

Un autre but de l'invention est de proposer un appareil électroménager équipé d'une pompe piézo-électrique dont le circuit d'alimentation garantit une régularité du débit fourni par la pompe

Ces buts sont atteints avec un circuit d'alimentation électrique d'une pompe piézo-électrique à partir du réseau électrique tel que défini par la revendication 1.

Par réseau électrique, on entend le réseau électrique domestique délivrant un courant de type alternatif de tension comprise, suivant le pays où on se trouve, entre 100 volts et 240 volts et de fréquence comprise entre 50 hertz et 60 hertz.

Selon l'invention, le circuit d'alimentation applique une tension dont la fréquence est issue directement du réseau électrique, sans modification ni transformation, ce qui permet d'obtenir un circuit très simple.

De plus, le circuit comporte des moyens pour limiter le courant absorbé par la pompe disposés en série. Cette disposition permet de protéger la pompe et d'assurer un fonctionnement fiable dans des conditions particulières du type branchement sur le réseau, fonctionnement à vide ou parasites sur le réseau.

Avantageusement, les moyens pour limiter le courant absorbé par la pompe comportent une résistance.

Cette disposition permet d'obtenir un circuit d'alimentation très simple et très économique.

De préférence, le circuit comporte au moins une résistance en parallèle avec la pompe.

Cette disposition permet de protéger la pompe et d'assurer un fonctionnement fiable lors de la coupure de l'alimentation de la pompe.

Avantageusement, le circuit comporte des moyens pour limiter la tension aux bornes de la pompe, disposés en parallèle avec ladite pompe.

Cette disposition permet de s'affranchir des fluctuations du réseau et des variations des caractéristiques physiques de l'élément piézo-électrique (comme par exemple la capacité) et ainsi d'obtenir un débit régulier de la pompe.

De préférence, les moyens pour limiter la tension aux bornes de la pompe disposés en parallèle avec ladite pompe comportent au moins deux diodes Zener.

Cette disposition permet de réaliser cette fonction avec des composants économiques du commerce.

L'invention concerne également un appareil électroménager comportant une pompe piézo-électrique et un circuit d'alimentation de ladite pompe, caractérisé en ce que ledit circuit d'alimentation est conforme à l'invention.

Cette disposition permet d'optimiser le coût d'un tel appareil à l'aide d'un circuit d'alimentation très économique.

Des circuits d'alimentation connus sont divulgués par JP 61-58286.

L'invention sera mieux comprise à l'étude du mode de réalisation pris à titre nullement limitatif et illustré dans les figures annexées dans lesquelles:
- La figure 1 illustre une vue schématique en coupe de l'appareil selon un mode particulier de réalisation de l'invention.
- La figure 2 illustre une vue en coupe de la pompe piézo-électrique de l'appareil de la figure 1.
- La figure 3 illustre une vue schématique du circuit d'alimentation de la pompe piézo-électrique de la figure 2.

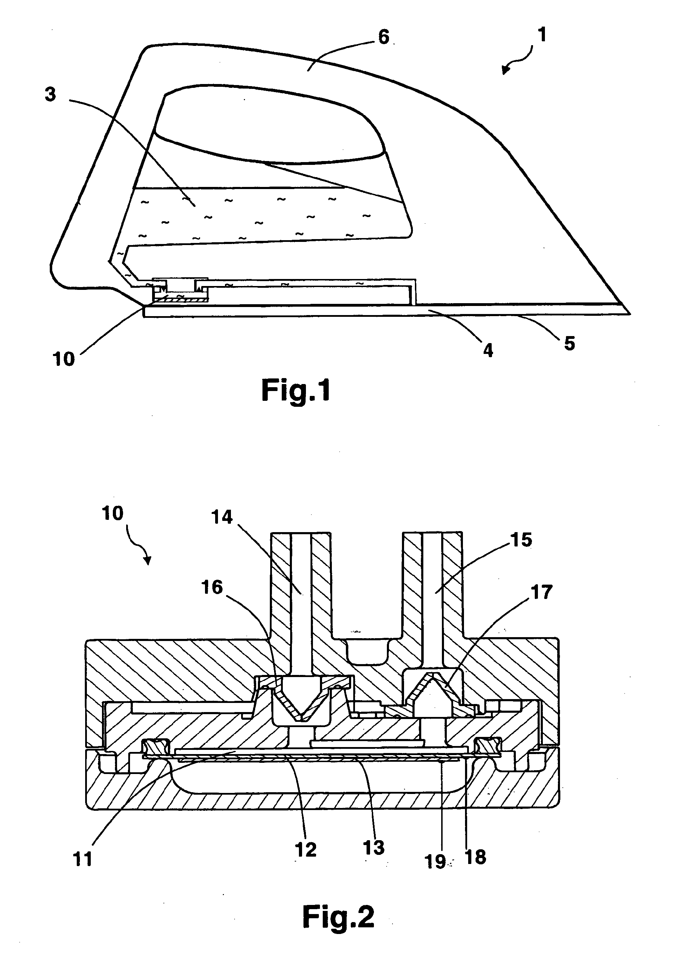

Comme visible sur la figure 1, l'appareil selon l'invention est un fer à repasser 1 comportant une pompe 10 piézo-électrique qui permet de transférer de l'eau d'un réservoir 3 vers une chambre de vaporisation 4 comprise dans une semelle 5 chauffante, munie d'ouvertures de diffusion de vapeur.

Tel que visible sur la figure 2, la pompe 10 piézo-électrique comporte une chambre circulaire 11 comprenant une paroi inférieure formée par une membrane souple 12 en laiton. Un élément piézo-électrique 13 en céramique est fixé sur la membrane 12, à l'extérieur de la chambre circulaire 11. La chambre circulaire 11 comprend une paroi supérieure munie d'un conduit d'admission 14 relié au réservoir 3 et d'un conduit d'évacuation 15 relié à la chambre de vaporisation 4.

La pompe 10 piézo-électrique comporte une borne d'alimentation électrique 18 fixée sur la membrane 12 et une borne d'alimentation électrique 19 fixée sur l'élément piézo-électrique 13. La pompe 10 est alimentée à ses bornes 18, 19 par une tension électrique alternative.

Lors de l'alternance positive du signal, l'élément piézo-électrique 13 se déforme, entraînant la membrane 12, de façon à augmenter le volume de la chambre circulaire 11. Le conduit d'évacuation 15 comporte un clapet anti retour 17 qui se ferme et empêche l'aspiration de l'eau présente en aval du clapet 17. Le conduit d'admission 14 comporte également un clapet anti retour 16 qui s'ouvre et permet ainsi à l'eau présente dans le conduit d'admission 14, issue du réservoir 3 (fig. 1), d'être aspirée dans la chambre circulaire 11.

Lors de l'alternance négative du signal, l'élément piézo-électrique 13 se déforme, entraînant la membrane 12, de façon à diminuer le volume de la chambre circulaire 11. Le clapet 16 du conduit d'admission 14 se ferme et dans le même temps, le clapet 17 du conduit d'évacuation 15 s'ouvre. Ainsi, l'eau va passer de la chambre circulaire 11 vers la chambre de vaporisation 4 (fig. 1). L'élément piézo-électrique 13 et la membrane 12 forment un actionneur piézo-électrique choisi parmi des modèles du commerce, fabriqués en grande série.

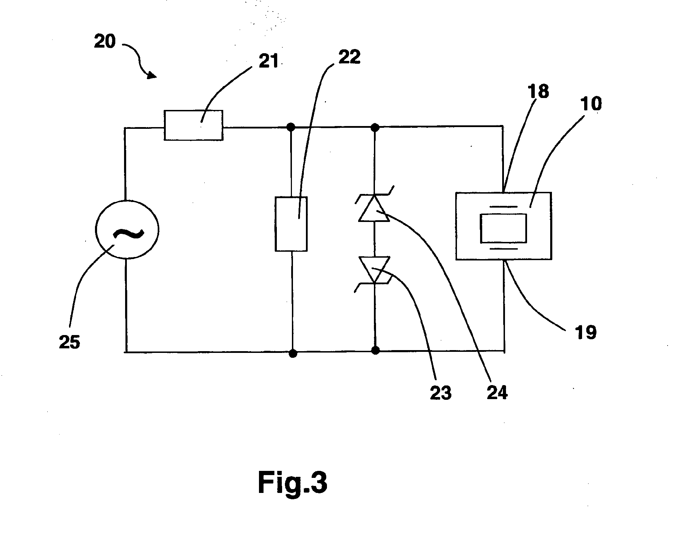

Tel que visible à la figure 3, la pompe 10 piézo-électrique est alimentée par un circuit d'alimentation 20 à partir d'un réseau électrique 25 délivrant une tension alternative, par exemple 230 volts, à une fréquence, par exemple 50 hertz, cette fréquence étant appliquée sans modification aux bornes 18, 19 de la pompe 10.

Le circuit d'alimentation 20 comporte une résistance 21, disposée en série avec la pompe 10, qui permet de limiter le courant absorbé par la pompe 10 dans les différentes phases critiques de fonctionnement pouvant survenir lors de l'utilisation de l'appareil 1 et qui contribue à protéger l'élément piézo-électrique 13.

Dans une première phase critique, lorsque l'on branche la pompe 10 directement sur le réseau électrique 25, l'actionneur piézo-électrique, qui est assimilable à une capacité, est tout d'abord équivalent à un court circuit qui appelle un pic de courant. Le pic de courant est d'autant plus élevé que la mise sous tension se produit à un niveau de tension proche du sommet de l'alternance. Pour un réseau électrique délivrant une tension de 230 volts, l'actionneur piézo-électrique peut être soumis à une tension maximum de 230 x √2 = 325 volts.

Une deuxième phase critique apparaît également lorsque la pompe 10 est alimentée alors que sa chambre circulaire 11 est vide (on appelle ce type de fonctionnement « fonctionnement à vide ou à sec »), l'actionneur piézo-électrique s'échauffe. Ceci a pour conséquence de modifier sa capacité et de faire augmenter le courant qu'il consomme. L'augmentation du courant consommé accélère l'échauffement et le phénomène s'emballe jusqu'à la destruction de l'élément piézo-électrique 13.

Dans une troisième phase critique, le ou les pics de courant sont des parasites amenés par le réseau électrique.

De manière préférentielle, le circuit d'alimentation 20 comporte également une résistance 22 disposée en parallèle avec la pompe 10. Cette résistance 22 permet de décharger l'actionneur piézo-électrique, équivalent électriquement à une capacité, après la coupure de son alimentation, et permet également de protéger l'actionneur piézo-électrique contre une surintensité lors du rebranchement sur le réseau électrique 25.

Ainsi, à titre d'exemple, l'actionneur piézo-électrique comporte un élément piézo-électrique 13 en céramique et une membrane souple 12, tous deux d'épaisseur comprise entre 0,005 et 1 millimètre, de préférence 0,3 millimètre.

La résistance 21 a une valeur comprise entre 1 et 100 kilo ohms, de préférence 15 kilo ohms, et la résistance 22 a une valeur comprise entre 100 et 2000 kilo ohms, de préférence 1000 kilo ohms.

De manière avantageuse, le circuit d'alimentation 20 comporte également deux diodes Zener 23, 24 disposées tête-bêche en parallèle avec la pompe 10. Ces diodes Zener 23, 24 permettent de limiter la tension aux bornes 18, 19 de la pompe, une diode pour l'alternance positive et l'autre diode pour l'alternance négative. Ainsi, on s'affranchit des fluctuations de la tension délivrée par le réseau électrique pour garantir une régularité du débit fourni par la pompe 10. Ainsi, à titre d'exemple, pour un réseau électrique délivrant une tension de 230 volts, les diodes 23, 24 écrêtent la tension à une valeur comprise entre 80 et 200 volts, de préférence 180 volts.

Une telle caractéristique permet notamment d'être conforme aux futurs accords CECED entre les fabricants de fers à repasser, applicables en juillet 2008, sur la précision du débit de vapeur annoncé par rapport au débit réel d'un fer.

Les résistances 21, 22 font baisser la valeur maximum du signal aux bornes de la pompe 10 et les diodes Zener 23, 24 vont écrêter ce même signal mais la fréquence est identique à la fréquence du réseau électrique.

Le fer à repasser 1 (Fig. 1) comporte une poignée 6. De manière avantageuse, le circuit d'alimentation (non représenté sur la fig. 1) est agencé dans la poignée 6 pour éviter les contraintes thermiques sur ce circuit d'alimentation.

Bien entendu, l'invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention.

Ainsi, une impédance de type capacité peut être ajoutée à la résistance disposée en série avec la pompe pour limiter le courant absorbé.

## Revendications

1. Circuit (20) d'alimentation électrique d'une pompe (10) piézo-électrique à partir du réseau électrique (25) domestique, directement à la fréquence du réseau électrique (25), ledit circuit (20) comportant au moins des moyens pour limiter le courant absorbé par la pompe (10), disposés en série avec ladite pompe (10), et au moins une résistance (22) en parallèle avec la pompe (10), **caractérisé en ce que** les moyens pour limiter le courant absorbé par la pompe (10) sont distincts de la résistance (22) et **en ce que** les moyens pour limiter le courant absorbé par la pompe (10) et la résistance (22) ont des valeurs fixes.

2. Circuit (20) d'alimentation électrique d'une pompe (10) piézo-électrique selon la revendication 1, **caractérisé en ce que** les moyens pour limiter le courant absorbé par la pompe (10) comportent une résistance (21).

3. Circuit (20) d'alimentation électrique d'une pompe (10) piézo-électrique selon l'une quelconque des revendications 1 à 2, **caractérisé en ce que** ledit circuit (20) comporte des moyens (23, 24) pour limiter la tension aux bornes de la pompe (10), disposés en parallèle avec ladite pompe (10).

4. Circuit (20) d'alimentation électrique d'une pompe piézo-électrique selon l'une quelconque des revendications 1 à 3, **caractérisé en ce que** les moyens pour limiter la tension aux bornes de la pompe (10) disposés en parallèle avec ladite pompe (10) comportent au moins deux diodes Zener (23, 24).

5. Appareil électroménager comportant une pompe (10) piézo-électrique et un circuit (20) d'alimentation électrique de ladite pompe (10), **caractérisé en ce que** ledit circuit (20) d'alimentation électrique est conforme à l'une des revendications 1 à 4.

## Patentansprüche

1. Schaltkreis (20) für die elektrische Versorgung einer piezoelektrischen Pumpe (10) ausgehend vom Haushaltsstromnetz (25), direkt mit der Frequenz des Stromnetzes (25), wobei der Schaltkreis (20) wenigstens Mittel zum Begrenzen des von der Pumpe (10) aufgenommenen Stromes, die in Serie mit der Pumpe (10) angeordnet sind, und wenigstens einen Widerstand (22) umfasst, der mit der Pumpe (10) parallel geschaltet ist, **dadurch gekennzeichnet, dass** die Mittel zum Begrenzen des von der Pumpe (10) aufgenommenen Stromes vom Widerstand (22) verschieden sind und dass die Mittel zum Begrenzen des von der Pumpe (10) aufgenommenen Stromes und der Widerstand (22) Fixwerte haben.

2. Schaltkreis (20) für die elektrische Versorgung einer piezoelektrischen Pumpe (10) nach Anspruch 1, **dadurch gekennzeichnet, dass** die Mittel zum Begrenzen des von der Pumpe (10) aufgenommenen Stromes einen Widerstand (21) umfassen.

3. Schaltkreis (20) für die elektrische Versorgung einer piezoelektrischen Pumpe (10) nach einem der Ansprüche 1 bis 2, **dadurch gekennzeichnet, dass** der Schaltkreis (20) Mittel (23, 24) zum Begrenzen der Spannung an den Anschlussklemmen der Pumpe (10) umfasst, die mit der Pumpe (10) parallel geschaltet sind.

4. Schaltkreis (20) für die elektrische Versorgung einer piezoelektrischen Pumpe (10) nach einem der Ansprüche 1 bis 3, **dadurch gekennzeichnet, dass** die Mittel zum Begrenzen der Spannung an den Anschlussklemmen der Pumpe (10), die mit der Pumpe (10) parallel geschaltet sind, wenigstens zwei Zener-Dioden (23, 24) umfassen.

5. Elektrohaushaltsgerät, umfassend eine piezoelektrische Pumpe (10) und einen Schaltkreis (20) für die elektrische Versorgung der Pumpe (10), **dadurch gekennzeichnet, dass** der Schaltkreis (20) für die elektrische Versorgung einem der Ansprüche 1 bis 4 entspricht.

## Claims

1. A circuit (20) for supplying power to a piezoelectric pump (10) from the household electric network (25), directly at the frequency of the electric network (25), said circuit (20) comprising at least one means for limiting the current absorbed by the pump (10), arranged in series with said pump (10), and at least one resistor (22) parallel to the pump (10), **characterised in that** the means for limiting the current absorbed by the pump (10) is distinct from the resistor (22) and **in that** the means for limiting the current absorbed by the pump (10) and the resistor (22) have fixed values.

2. A circuit (20) for supplying power to a piezoelectric pump (10) according to claim 1, **characterised in that** the means for limiting the current absorbed by the pump (10) contains a resistor (21).

3. A circuit (20) for supplying power to a piezoelectric pump (10) according to any one of claims 1 to 2, **characterised in that** said circuit (20) comprises means (23, 24) for limiting the voltage at the terminals of the pump (10), arranged in parallel to said pump (10).

4. A circuit (20) for supplying power to a piezoelectric pump (10) according to any one of claims 1 to 3, **characterised in that** the means for limiting the voltage at the terminals of the pump (10) arranged in parallel to said pump (10) contains at least two Zener diodes (23,24).

5. An electrical household appliance comprising a piezoelectric pump (10) and a circuit (20) for supplying power to said pump (10), **characterised in that** said circuit (20) for supplying power conforms to one of claims 1 to 4.
